# EUROPEAN PATENT APPLICATION

(11) **EP 4 379 811 A2**
(43) Date of publication of application: **05.06.2024**
(21) Application number: 23199260.3
(22) Date of filing: 25.09.2023
(51) Int. Cl.: H01L 29/778, H01L 21/337, H01L 29/06, H01L 29/40, H01L 29/10, H01L 29/20

(54) **HIGH-ELECTRON-MOBILITY TRANSISTOR**

(30) Priority: 29.11.2022 US 202218070800
(71) Applicant: GlobalFoundries U.S. Inc., Malta, NY 12020 (US)
(72) Inventor: SHARMA, Santosh, Austin, TX, 78735 (US); KRISHNASAMY, Rajendran, Essex Junction, VT, 05452 (US); KANTAROVSKY, Johnatan A., Essex Junction, VT, 05452 (US)
(74) Representative: Lambacher, Michael

(57) **Abstract**

Semiconductor structures and, more particularly, a high-electron-mobility transistor and methods of manufacture thereof are disclosed. The structure includes: a gate structure (18, 22, 28); and a channel region (14, 16) under the gate structure, the channel region having a first portion including a first thickness and a second portion having a second thickness greater than the first thickness, the second portion being positioned remotely from the gate structure.

## Description

This invention was made with government support under Contract # HQ0727790700 awarded by the Defense Microelectronics Agency (DMEA). The government has certain rights in the invention.

### BACKGROUND

The present disclosure relates to semiconductor structures and, more particularly, to a high-electron-mobility transistor and methods of manufacture.

A high-electron-mobility transistor (HEMT) is a field-effect transistor incorporating a junction between two materials with different band gaps (i.e. a heterojunction) as the channel, instead of a doped region (as is generally the case for a MOSFET). Commonly used material combinations are GaN or GaAs, although other materials can be used dependent on the application of the device.

HEMTs are able to operate at higher frequencies than ordinary transistors, up to millimeter wave frequencies. With this noted, GaN HEMT devices may have a higher electric-field strength than conventional MOSFETS, providing further performance improvements in, for example, on-resistance and breakdown voltage while offering fast switching speed amongst other important parameters. As the HEMTs are able to operate at higher frequencies, they can be used in high-frequency products such as cell phones, satellite television receivers, voltage converters, and radar equipment. For example, a HEMT may be used in satellite receivers and in low power amplifiers.

### SUMMARY

In an aspect of the disclosure, a structure comprises: a gate structure; and a channel region under the gate structure, the channel region comprising a first portion comprising a first thickness and a second portion comprising a second thickness greater than the first thickness, the second portion being positioned remotely from the gate structure.

Additional features of the structure are set forth in dependent claims 2 to 7.

In an aspect of the disclosure, a structure comprises: a gate structure comprising GaN; a channel region comprising semiconductor material under the gate structure, the semiconductor material having a different thickness under the gate structure than adjacent a drain region of the gate structure; and a field plate over the semiconductor material.

Additional features of the structure are set forth in dependent claims 9 to 14.

In an aspect of the disclosure, a method comprises: forming a gate structure; and forming a channel region under the gate structure, the channel region comprising a first portion comprising a first thickness and a second portion comprising a second thickness greater than the first thickness, the second portion being positioned remotely from the gate structure.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a device and respective fabrication processes in accordance with aspects of the present disclosure
FIGS. 2A-2D show respective fabrication processes for manufacturing the device of FIG. 1 in accordance with aspects of the present disclosure

### DETAILED DESCRIPTION

The present disclosure relates to semiconductor structures and, more particularly, to a high-electron-mobility transistor and methods of manufacture. More specifically, the high-electron-mobility transistor (HEMT) includes a channel with a thicker channel region and a thinner channel region. Advantageously, the use of the thicker channel region provides an improved on resistance from drain to source (Rds(on)) and improved Ron*Qoss (total output charge).

In more specific embodiments, a HEMT comprises a first semiconductor layer having a first portion and a second portion. The second portion has a top surface higher than a top surface of the first portion. A gate structure (e.g., gate electrode) is positioned over the first portion and remote from the second portion. A step is formed at a junction of the first portion and the second portion. The step is spaced apart from the gate structure. A field plate overlaps with the first portion and the second portion. The second portion surrounds the first portion. In embodiments, the second portion may have a thickness about twice the first portion and may have different Al concentrations near a top surface than near a bottom surface.

The HEMT of the present disclosure can be manufactured in a number of ways using a number of different tools. In general, though, the methodologies and tools are used to form structures with dimensions in the micrometer and nanometer scale. The methodologies, i.e., technologies, employed to manufacture the HEMT of the present disclosure have been adopted from integrated circuit (IC) technology. For example, the structures are built on wafers and are realized in films of material patterned by photolithographic processes on the top of a wafer. In particular, the fabrication of the HEMT uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

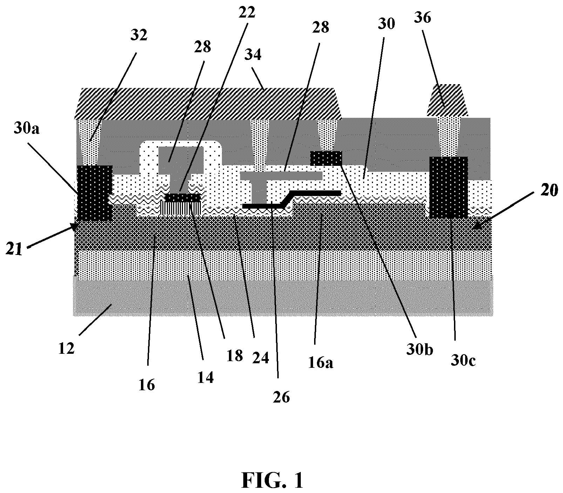

FIG. 1 shows a device and respective fabrication processes in accordance with aspects of the present disclosure. In embodiments, the device 10 may be a HEMT device or, more specifically, a metal oxide semiconductor HEMT (MOSHEMT) device.

The device 10 of FIG. 1 includes a semiconductor substrate 12 with buffer layer 14 over the semiconductor substrate 12 and a semiconductor material 16 over the buffer layer 14. In embodiments, the semiconductor substrate 12 may be, e.g., Si, SiC, Sapphire, semiconductor on insulator (SOI) technology, GaN or Qromis' substrate technology (QST). In alternative embodiments, the semiconductor substrate12 may be any suitable material including, but not limited to, SiGe, SiGeC, GaAs, InAs, InP, and other III/V or II/VI compound semiconductors. In preferred embodiments, the semiconductor substrate 12 comprises p-type Si material with a suitable crystal orientation, e.g., (111).

The buffer layer 14 may be any semiconductor material that acts as a buffer material in a HEMT device as is known in the art. For example, the buffer layer 14 may be GaN. The semiconductor material 16 may be AlGaN. The AlGaN/GaN may act as a conducting channel for the HEMT device, e.g., for gate structure 18.

In embodiments, the semiconductor material 16 includes a thicker portion 16a between the gate structure 18 and a drain region 20. The thicker portion 16a may act to reduce channel resistance between the gate structure 18 and the drain region 20. For example, the increased volume of semiconductor material at the thicker portion 16a allows an increase in carrier concentration of 2DEG (e.g., 2-dimensionasl electron gas) in the channel at the thicker portion 16a. This increased volume effectively reduces the channel resistance of the semiconductor material 16.

The thicker portion 16a has a top surface which is higher than the top surface of the remaining semiconductor material 16 under the gate structure 18, resulting in a step feature. In preferred embodiments, the thicker portion 16a is separated or remote from the gate structure 18. In embodiments, the thicker portion 16a may be twice as thick as the semiconductor material 16 under the gate structure 18, as an illustrative example; although other dimensions are also contemplated herein. The thicker portion 16a may be additional AlGaN epitaxially grown on the semiconductor material 16. The thicker portion 16a may also have a different Al concentration near than the top surface than near a bottom surface.

Still referring to FIG. 1, the semiconductor material 18 (e.g., gate structure) and conductive material 22 may be formed, e.g., deposited and patterned, on the semiconductor material 16. In embodiments, the semiconductor material 18 comprises, e.g., p-doped GaN, and the conductive material 22 may be, e.g., TiN. The materials 18, 22 may be deposited by a conventional deposition method (e.g., chemical vapor deposition (CVD)), followed by conventional lithography and etching processes.

A dielectric material 24 may be formed over the gate structure, e.g., materials 18, 22, and the semiconductor material 16. In embodiments, the dielectric material 24 may be formed over the thicker portion 16a. The dielectric material 24 may be any known passivation layer such as, e.g., AlO₂ or SiO₂.

A field plate 26 may be formed in contact with the dielectric material 24, partially extending over the thicker portion 16a of the semiconductor material 16. In embodiments, the field plate 26 may comprise TiN. In embodiments, the field plate 26 may be connected back to a source region 21 (through the conductive features 28, 32, 34, 30a as described herein).

A gate contact metal 28 may be formed in contact with the field plate 26 and the conductive material 22, e.g., TiN, of the gate structure 18. The gate contact metal 28 may be, e.g., TiAl or TiN, formed by patterning of interlevel dielectric material 30 to expose the underlying field plate 26 and the conductive material 22, e.g., TiN, followed by deposition of conductive material, e.g., TiN.

Still referring to FIG. 1, ohmic contacts 30a, 30c may contact (e.g., electrically connect) to the underlying semiconductor material 16 (e.g., conducting channel of the source region 21 and the drain region 20); whereas ohmic contacts 30b may contact the gate contact metal 28. Back end of the line contacts (e.g., metal vias) 32 may connect to the ohmic contacts 30a-30c and the field plate 26 through the gate contact metal 28. In embodiments, the ohmic contacts 30a-30c may be formed using conventional lithography, etching and deposition processes as is known in the art. The ohmic contacts 30a-30c may comprise, e.g., TiAl or TiN.

Metal wiring 34, 36 connect to the source region 21 and the drain region 20, respectively. In embodiments, the metal wiring 34, 36 may electrically connect and be in direct contact with the via contacts 32. The metal wiring 34, 36 to the source region 21 and the drain region 20 may be formed by a back end of the line metal processes (e.g., TiN liner with tungsten fill) as is known in the art.

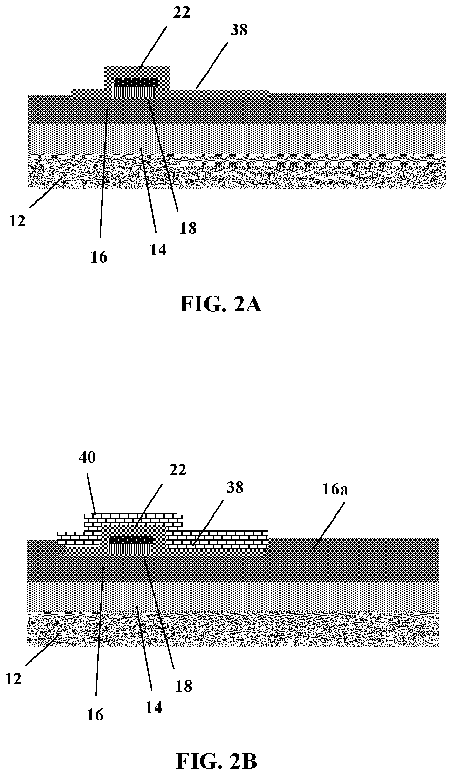

FIGS. 2A-2D show respective fabrication processes for manufacturing the HEMT device of FIG. 1 in accordance with aspects of the present disclosure More specifically, FIG. 2A shows the buffer layer 14 formed over the semiconductor substrate 12 and the semiconductor material 16 formed over the buffer layer 14. In embodiments, the buffer layer 14 and semiconductor material 16 may be formed by a semiconductor epitaxial growth process or other deposition process as is known in the art such that no further explanation is required for a complete understanding of the present disclosure.

The gate structure 18 and conductive material 22 may be formed on the semiconductor material 16 (e.g., conducting channel). In embodiments, the gate structure 18 may be pGaN material deposited on the semiconductor material 16 using any conventional deposition method. For example, the pGaN material may be formed by an epitaxial growth process with an in-situ process using p-type dopant, e.g., boron. The conductive material 22, e.g., TiN, may be deposited using a conventional CVD process. The semiconductor material of the gate structure 18 and the conductive material 22 undergo conventional lithography and etching processes to form the gate structure 18 with a top layer of conductive material 22.

A mask 38 may be selectively deposited on the conductive material 22 and adjacent regions of the semiconductor material 16. The mask 38 may be an oxide material or a nitride material, as examples. The mask 38 will prevent channel material (e.g., AlGaN) from growing on the gate structure and adjacent regions.

In FIG. 2B, AlGaN material is epitaxially grown on the semiconductor material 16 to form the thicker portion 16a. The AlGaN material will form an amorphous semiconductor material 40 on the mask 30.

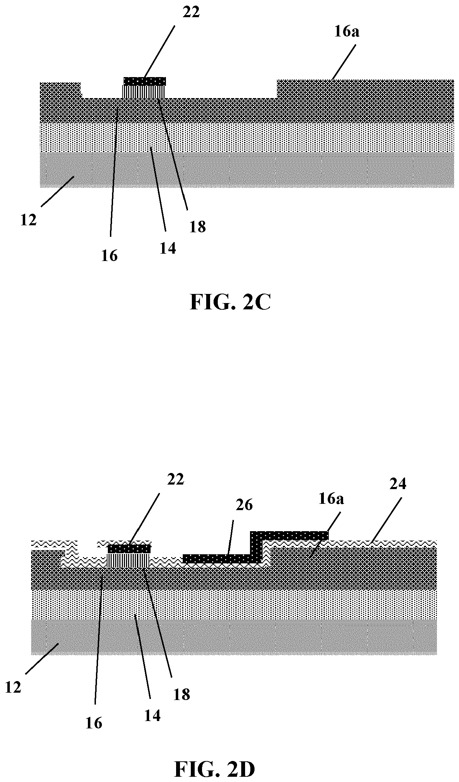

In FIG. 2C, the amorphous semiconductor material 40 and the mask 30 is removed from over the gate structure 18 (e.g., conductive material 22 of the gate structure 18) and adjacent regions. In embodiments, the amorphous semiconductor material 40 and the mask 30 may be removed by a selective etching process, e.g., reactive ion etch (RIE) with a selective chemistry that will strip or remove the amorphous semiconductor material 40 and the mask 30. In this process, the thicker portion 16a will remain intact and be separated from the gate structure 18.

In FIG. 2D, the dielectric material 24 may be formed over the gate structure 18 (e.g., conductive material 22 on the gate structure 18) and the semiconductor material 16 including on the thicker portion 16a (and stepped feature). The dielectric material 24 may be any appropriate passivation material such as, e.g., AlO₂ or SiO₂. A field plate metal may be deposited on the dielectric material 24 using a conventional deposition process, e.g., CVD. The field plate metal may be patterned by a conventional lithography and etching processes to form the field plate 26 on the semiconductor material 16 and extending onto the stepped portion and onto the thicker portion 16a.

Referring back to FIG. 1, the gate contact metal 28 may be formed in contact with the field plate 26 and the conductive material 22, e.g., TiN, of the gate structure 18 as already described herein. The ohmic contacts 30a, 30c may be formed in contact (e.g., electrically connect) to the underlying semiconductor material 16 (e.g., conducting channel of the source region 21 and the drain region 20); whereas ohmic contacts 30b may be formed in contact the gate contact metal 28. The ohmic contacts 30a, 30b, 30c may be formed by conventional patterning and deposition processes, e.g., patterning of the dielectric material and deposition of the metal material for the ohmic contacts 30a, 30b, 30c. Back end of the line contacts (e.g., metal vias) 32 and metal wiring 34, 36 may be formed by conventional back end of the line processes such that no explanation is required herein for a complete understanding of the present disclosure.

The HEMT can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multichip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a gate structure; and
a channel region under the gate structure, the channel region comprising a first portion comprising a first thickness and a second portion comprising a second thickness greater than the first thickness, the second portion being positioned remotely from the gate structure.

2. The structure of claim 1, wherein the channel region comprises AlGaN and/or the gate structure comprises pGaN, wherein a junction between the first portion and the second portion optionally comprises a stepped portion.

3. The structure of claim 2, wherein the stepped portion is remote from the gate structure.

4. The structure of claim 2 or 3, further comprising a field plate that extends over the first portion, second portion and the stepped portion.

5. The structure of claim 4, further comprising an insulator material between the field plate and both the first portion and the second portion.

6. The structure of claim 2, wherein the second thickness comprises an Al concentration different at a top surface than a bottom surface.

7. The structure of one of claims 1 to 6, wherein the second portion is twice as thick as the first portion, wherein the thicker portion optionally extends over a drain region of the gate structure.

8. A structure comprising:
a gate structure comprising GaN or pGaN;
a channel region comprising semiconductor material under the gate structure, the semiconductor material having a different thickness under the gate structure than adjacent a drain region of the gate structure; and
a field plate over the semiconductor material.

9. The structure of claim 8, wherein the semiconductor material comprises AlGaN.

10. The structure of claim 8 or 9, further comprising a stepped region between the different thickness of the semiconductor material, the stepped region being positioned away from the gate structure.

11. The structure of one of claims 8 to 10, wherein the field plate comprises metal material extending over the different thickness of the semiconductor material.

12. The structure of claim 11, further comprising an insulator material between the field plate and the semiconductor material.

13. The structure of one of claims 8 to 12, wherein the semiconductor material comprises a first thickness and a second thickness, the second thickness being greater than the first thickness and being separated from the gate structure, wherein the second thickness optionally comprises an Al concentration different at a top surface than a bottom surface.

14. The structure of claim 13, wherein the second thickness extends over the drain region of the gate structure and the field plate extends over the first thickness and the second thickness of the semiconductor material.

15. A method comprising:
forming a gate structure; and
forming a channel region under the gate structure, the channel region comprising a first portion comprising a first thickness and a second portion comprising a second thickness greater than the first thickness, the second portion being positioned remotely from the gate structure.
